# FASCICULE DE BREVET EUROPEEN

(11) **EP 3 394 912 B1**
(45) Date de publication et mention de la délivrance du brevet: **17.02.2021**
(21) Numéro de dépôt: 16812967.4
(22) Date de dépôt: 21.12.2016
(51) Int. Cl.: H01L 51/42, H01L 27/30

(54) **DISPOSITIF OPTOELECTRONIQUE ORGANIQUE, MATRICE DE TELS DISPOSITIFS ET PROCEDE DE FABRICATION DE TELLES MATRICES**
ORGANISCHE OPTOELEKTRONISCHE VORRICHTUNG, MATRIX SOLCHER VORRICHTUNGEN UND VERFAHREN ZUR HERSTELLUNG SOLCHER MATRIZEN
ORGANIC OPTOELECTRONIC DEVICE, ARRAY OF SUCH DEVICES AND METHOD FOR PRODUCING SUCH ARRAYS

(30) Priorité: 23.12.2015 FR 1563286
(43) Date de publication de la demande: 31.10.2018
(73) Titulaire: Commissariat à l'Énergie Atomique et aux Énergies Alternatives, 75015 Paris (FR); ISORG, 38000 Grenoble (FR); Trixell, 38430 Moirans (FR)
(72) Inventeur: BENWADIH, Mohammed, 94500 Champagny Sur Marne (FR); CHARLOT, Simon, 38620 Montferrat (FR); LAURENT, Jean-Yves, 38400 Domene (FR); VERILHAC, Jean-Marie, 38500 Coublevie (FR); BERTHOD, Emeline, 38040 GRENOBLE Cedex 09 (FR); ROHR, Pierre, 38430 Moirans (FR)
(74) Mandataire: Marks & Clerk France
(86) Numéro de dépôt international: PCT/EP2016/082064
(87) Numéro de publication internationale: WO 2017/108882

(56) Documents cités:
- EP-A1- 2 490 235
- WO-A1-2011/141717
- WO-A1-2015/169623
- WO-A2-2012/135527
- US-A1- 2012 060 926
- US-A1- 2013 269 766

## Description

L'invention concerne un dispositif optoélectronique organique et une matrice de tels dispositifs, de type matrice de photodétecteurs (imageur pixélisé) ou matrice d'affichage. L'invention s'applique notamment, mais pas exclusivement, à la réalisation d'imageurs à rayons X matriciels de grande surface pour la radiologie médicale, le contrôle non destructif ou la sécurité, basés sur un principe de détection indirecte et utilisant, de préférence, des semi-conducteurs organiques.

Dans le domaine de l'imagerie par rayons X, deux modes de détection sont couramment employés. Un premier mode, dit mode de détection directe, consiste à utiliser une matrice de photodétecteurs, chaque photodétecteur étant apte à convertir les rayons X qu'il absorbe en charge électrique. Un second mode, dit indirect, consiste à convertir dans un premier temps les rayons X en photons visibles, via un scintillateur, et dans un second temps à utiliser une matrice de photodétecteurs pour convertir les photons visibles produits en charge électrique. L'invention concerne une matrice de pixels pour la détection indirect des rayons X, chaque pixel étant composé d'au moins un transistor (de type TFT pour *thin film transistor*) couplé à un photodétecteur organique. Dans chacun des pixels, un transistor est couramment relié à une première électrode d'un photodétecteur organique.

Une couche adaptée à la photo-conversion de la lumière est couramment déposée sur la première électrode. Cette couche peut par exemple être organique et comporter un mélange nanostructuré de semi-conducteurs de type p et de type n (Li, G., Shrotriya, V., Huang, J., Yao, Y., Moriarty, T., Emery, K., & Yang, Y., 2005, High-efficiency solution processable polymer photovoltaic cells by self-organization of polymer blends, Nature materials, 4(11), 864-868). Une électrode supérieure est ensuite déposée sur la couche de photo-conversion.

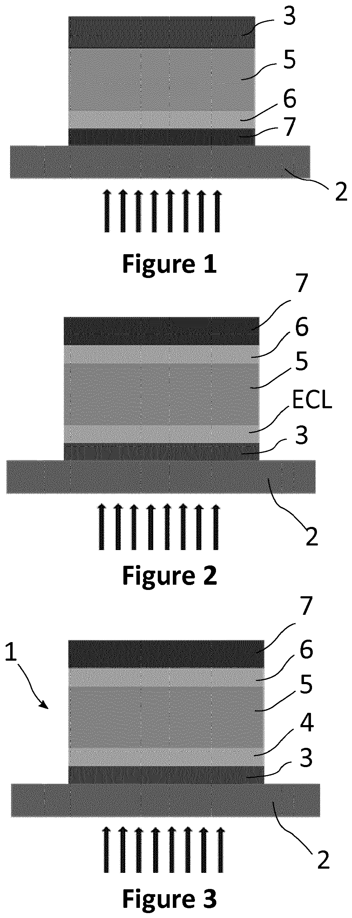

La figure 1 illustre schématiquement la structure d'une photodiode organique, selon l'art antérieur. L'empilement comporte par exemple un substrat transparent (en verre, polyéthylène naphtalate (PEN) ou en polyéthylène téréphtalate (PET)). Ce substrat est recouvert d'une électrode transparente métallique (par exemple en oxyde d'indium dopé à l'étain (ITO, acronyme anglais de *Indium Tin Oxide),* puis d'une couche de collection des trous (HCL, pour *Hole Collecting Layer*), apte à collecter les trous lors d'une illumination, par exemple réalisée en poly(3,4-éthylènedioxythiophène) et poly(styrène sulfonate) de sodium (PEDOT:PSS). Ces couches sont recouvertes d'une couche adaptée à la photo-conversion, dite couche active, réalisée tel que décrit précédemment. Enfin, la couche active est recouverte d'une couche de collection des électrons (ECL, pour *Electron Collecting Layer*), par exemple réalisée en aluminium. Dans l'exemple illustré par la figure 1, l'éclairage de la photodiode est réalisé par le substrat transparent : ce mode d'éclairage, ainsi que la structure de la photodiode, sont dit direct. Des couches de transport des porteurs de charges sont reliées électriquement aux couches de collection des porteurs de charges (HCL et ECL). Dans la structure directe illustrée en figure 1, le transport des trous est réalisé par un couche d'ITO et le transport des électrons est réalisé par une couche d'aluminium.

La figure 2 illustre schématiquement une photodiode organique de structure dite inverse selon l'art antérieur. La photodiode illustrée comporte un substrat transparent, recouvert d'une couche de transport des électrons (ETL) transparente, elle-même recouverte d'une couche de collections des électrons (ECL) transparente. Ces couches sont recouvertes d'une couche active et d'une couche de collection des trous (HCL). L'HCL est par exemple recouverte d'une couche d'argent, dont la fonction est à la fois de permettre le transport des trous (IITL) et de réfléchir la lumière incidente, provenant du substrat. L'ECL est par exemple réalisée en oxyde de zinc (ZnO) ou en oxyde de titane (TiOₓ) et la HCL est par exemple réalisée en PEDOT:PSS ou en oxyde métallique tel que l'oxyde de molybdène, l'oxyde de tungstène ou l'oxyde de vanadium. Une structure de ce type est divulguée par Jeong, J. et al., Inverted Organic Photodetectors With ZnO Electron-Collecting Buffer Layers and Polymer Bulk Heterojunction Active Layers, Selected Topics in Quantum Electronics, IEEE Journal of, 20(6), 130-136.

Dans les deux structures de photodiode, directe ou inverse, la lumière peut être absorbée par les différentes couches, en particulier par l'électrode supérieure et/ou l'électrode inférieure.

La fabrication d'une matrice de photodiodes organiques inverses telle que décrite précédemment est désirable pour des applications en imagerie médicale. Ce type d'imagerie nécessite des seuils de détection très faibles. Une des manières d'atteindre un seuil de détection faible est de limiter voir de supprimer le courant d'obscurité d'une photodiode, c'est-à-dire le courant résiduel de la photodiode en l'absence d'éclairement lumineux, lorsque la photodiode est polarisée. Un travail de sortie trop élevé du matériau de la couche de collection des électrons favorise une injection parasite de trous de cette couche vers le donneur de la couche active. Une des solutions de l'art antérieur est de réaliser une électrode inférieure (en contact avec le substrat) dans un matériau métallique dont le travail de sortie est inférieur aux matériaux couramment utilisés (généralement l'ITO). Par exemple, l'aluminium et le chrome possèdent un travail de sortie inférieur à l'ITO. Ces matériaux présentent l'inconvénient d'être instables en présence d'air car facilement oxydables.

Ce problème technique peut être partiellement résolu, comme décrit par Jeong, J. *et al.* en utilisant une couche de collection des électrons interstitielle entre l'électrode inférieure et la couche active, dont le rôle est de diminuer le travail de sortie du matériau au contact de la couche active : l'oxyde de zinc (ZnO) peut être utilisé à cet escient. Le ZnO employé est semi-conducteur : son utilisation lors d'un dépôt en plein champ (sans étape de lithographie délimitant des motifs) présente un problème technique, car des courants de fuite peuvent être générés entre les différents pixels d'une matrice de photodiode. Un pixel défectueux, par exemple dans le cas d'un travail de sortie qui n'est accidentellement pas adapté à la couche active, peut induire des courants de fuite à l'ensemble des pixels voisins et rendre la zone de pixels qui l'entoure inadaptée à l'imagerie. Une étape de lithographie permettant de graver la couche de collections des électrons afin de séparer les différents pixels électriquement pourrait être une solution technique. Cette étape n'est pas souhaitable dans un procédé de fabrication dans lequel une succession trop importante des étapes de lithographie nécessaires compromet la réalisation du dispositif et/ou son rendement de production.

Les documents suivants divulguent un dispositif optoélectronique similaire à celui de la présente invention : US 2013/269766 A1, US 2012/060926 A1, WO 2011/141717 A1, WO 2012/135527 A2, EP 2 490 235 A1 et WO 2015/169623 A1.

L'invention vise à remédier aux inconvénients précités de l'art antérieur, et plus particulièrement à réaliser un dispositif optoélectronique organique matriciel dont les courants de fuite sont minimisés tout en permettant une limitation des étapes de photolithographie lors de la fabrication d'un tel dispositif.

La présente invention concerne un dispositif optoélectronique selon la revendication 1.

Avantageusement, ledit travail de sortie Φ₁ de ladite couche de collection des électrons du dispositif est strictement inférieur audit travail de sortie Φ_{C} de ladite cathode.

Avantageusement, ledit matériau de ladite couche de collection des électrons du dispositif est choisi parmi l'oxyde de zinc et l'oxyde de titane.

Un autre objet de l'invention est un dispositif optoélectronique matriciel comportant une pluralité de dispositifs optoélectroniques et une couche de collection des électrons commune à au moins une partie desdits dispositifs optoélectroniques et matériellement continue entre chacun desdits dispositifs optoélectroniques.

Avantageusement, la résistance par carré R de ladite couche de collection commune du dispositif optoélectronique matriciel est apte à bloquer les courants de porteurs de charges entre lesdits dispositifs optoélectroniques de ladite ou desdites parties, dans ledit matériau de ladite couche de collection commune.

Avantageusement, le dispositif optoélectronique matriciel comporte au moins une couche de stabilisation agencée entre ladite couche de collection des électrons commune et au moins une couche active, dans lequel ladite couche de stabilisation est apte à réduire la dépendance de la résistivité du matériau d'une dite couche de collection des électrons commune en fonction de la luminosité.

Avantageusement, le matériau de ladite couche de stabilisation dudit dispositif optoélectronique matriciel est un oxyde opaque de préférence choisi parmi de l'oxyde d'étain, l'oxyde de palladium.

Avantageusement, le matériau de ladite couche de collection des électrons commune dudit dispositif optoélectronique matriciel comporte des éléments dopants de type p.

Avantageusement, lesdits éléments dopants de type p sont choisis parmi le palladium, le cobalt, le cuivre et le molybdène.

Avantageusement, au moins une dite couche de collection des électrons dudit dispositif optoélectronique matriciel comporte des nanoparticules d'oxyde métallique et des polymères polaires, lesdits polymères polaires étant greffés sur lesdites nanoparticules d'oxyde métallique.

Avantageusement, au moins un élément choisi parmi un substrat, une cathode , une couche de collection des électrons , une couche active , une couche de collection des trous et une anode dudit dispositif optoélectronique matriciel est transparent.

Avantageusement, ledit dispositif optoélectronique matriciel comportant une couche de matériau scintillateur, ladite couche étant agencée au dessus de chaque dite anode.

La présente invention concerne aussi un procédé de fabrication d'un dispositif optoélectronique selon les revendications 13, 14 et 16.

L'invention sera mieux comprise et d'autres avantages, détails et caractéristiques de celle-ci apparaîtront au cours de la description explicative qui suit, faite à titre d'exemple en référence aux dessins annexés dans lesquels :
- la figure 3 illustre schématiquement la structure d'un dispositif optoélectronique en structure inverse, selon un mode de réalisation de l'invention;
- la figure 4 illustre un diagramme de bande correspondant à une structure d'un dispositif optoélectronique selon l'art antérieur ;
- la figure 5 illustre un diagramme de bande correspondant à une structure d'un mode de réalisation de l'invention ;
- la figure 6 illustre schématiquement un dispositif optoélectronique matriciel selon un mode de réalisation de l'invention ;
- la figure 7 illustre schématiquement un dispositif optoélectronique matriciel, en vue de dessus, selon un mode de réalisation de l'invention ;
- la figure 8 illustre schématiquement la coupe d'une partie d'un dispositif optoélectronique, comportant une couche de collection des électrons comportant des cristallites ;
- la figure 9 illustre schématiquement des couches minces agencées sur le substrat d'un dispositif optoélectronique matriciel selon un mode de réalisation de l'invention;
- la figure 10 illustre dans un diagramme la variation de la concentration de précurseurs d'une réaction sol-gel normalisée ;
- la figure 11 illustre schématiquement l'influence de la taille de polymères précurseurs sur la distance entre des particules de ZnO ;
- la figure 12 illustre schématiquement la diminution de la conductivité électrique lors de la présence de résidus organiques dans une couche de collection des électrons ;
- la figure 13 illustre schématiquement un dispositif optoélectronique matriciel dans lequel la résistance d'une couche de collection des électrons est augmentée par une étape de gravure de ladite couche ;
- la figure 14 illustre un mode de réalisation de l'invention dans lequel un dispositif optoélectronique matriciel comporte une couche de matériau scintillateur.

La figure 1 illustre schématiquement la structure d'un dispositif optoélectronique de l'art antérieur. Le dispositif illustré est une photodiode de structure directe, telle que décrite précédemment.

La figure 2 illustre schématiquement une photodiode organique de structure dite inverse selon l'art antérieur.

La figure 3 illustre schématiquement la structure d'un dispositif optoélectronique 1 en structure inverse, selon un mode de réalisation de l'invention. Le dispositif optoélectronique 1 comporte un substrat 2 transparent au dessous duquel le dispositif optoélectronique 1 peut être éclairé. Par transparent, on entend apte à partiellement ou totalement transmettre les ondes électromagnétiques dont les longueurs d'ondes sont comprises dans la plage du visible et/ou des proches ultraviolets et/ou des proches infrarouges. L'éclairage est représenté par les flèches noires dirigées vers le haut dans la figure 3. Le substrat 2 peut être réalisé en verre, en PEN, en PET. Un empilement de couches minces planaires formant partiellement le dispositif optoélectronique 1 est agencé sur le substrat 2.

Une cathode 3 est agencée au dessus du substrat 2. La cathode 3 est réalisée dans un matériau dont le travail de sortie est noté Φ_{C}. Dans des réalisations de l'invention, une cathode 3 peut être réalisée en ITO. La cathode 3 peut être aussi qualifiée dans cette structure de couche de transport des électrons, ou ETL (pour *Electron Transport Layer*)*.*

Une couche de collection des électrons 4, est agencée au dessus de la cathode 3. Le travail de sortie du matériau de la couche de collection des électrons 4 est noté Φ₁ et la résistance par carré (mesurée en Ω/□ et/ou en Ω) de la couche de collection des électrons 4 est notée R. Dans des réalisations de l'invention, R est strictement supérieur à 10⁸ Ω, préférentiellement strictement supérieur à 10¹⁰ Ω et préférentiellement strictement supérieur à 10¹¹ Ω. La couche de collection des électrons 4 peut être réalisée en oxyde de titane (TiOₓ) ou en oxyde de zinc (ZnO).

Une couche active 5 est agencée au dessus de la couche de collection des électrons 4. Une couche active 5 comporte au moins un matériau semi-conducteur organique de type p, de niveau énergétique de la plus haute orbitale moléculaire occupée noté HO1 et un matériau semi-conducteur de type n, et est adaptée pour émettre ou détecter un rayonnement lumineux. La couche active 5 est agencée au dessus de ladite couche de collection des électrons 4. La couche active 5 comporte par exemple un mélange de polymères et de fullerènes. La couche active 5 est par exemple déposée par enduction, dans un solvant de type mésytilène, avec une épaisseur sèche de 200 nm après recuit thermique. Cette couche est un mélange nanostructuré entre un matériau donneur d'électron (poly(3-hexylthiophene)régio-régulier, connu comme P3HT RR) et un matériau accepteur d'électron (Di[1,4]methanonaphthaleno [1,2:2',3';56,60:2",3"][5,6]fullerene-C60-Ih, connu comme ICBA) avec un rapport massique de 1:2. La couche active 5 peut recouvrir toute la matrice. Elle peut aussi être déposée par pulvérisation (« spray coating ») dans un solvant de type chlorobenzène, avec une épaisseur sèche de 800 nm après recuit thermique. Cette couche peut aussi être un mélange nanostructuré entre un matériau donneur d'électron (Poly[(4,8-bis-(2-ethylhexyloxy)-benzo(1,2-b:4,5-b')dithiophene)-2,6-diyl-alt-(4-(2-thylhexanoyl)-thieno[3,4-b]thiophene-)-2-6-diyl)], connu comme PBDTTT-C) et un matériau accepteur d'électron ([6,6]-Phenyl-C71-butyric acid methyl ester , connu comme [70]PCBM) avec un rapport massique de 1:2.

Une couche de collection des trous 6 (HCL, pour *Holes Collection Layer*) est agencée au dessus de la couche active 5. Dans des réalisations de l'invention, la couche de collection des trous 6 est réalisée dans un matériau choisi parmi le PEDOT:PSS, l'oxyde de molybdène (MoO₃), l'oxyde de Tungstène (WO₃) et l'oxyde de Vanadium (V₂O₅).

Une anode 7 est agencée au dessus de la couche de collection des trous 6. Dans une réalisation de l'invention, l'anode est un réflecteur métallique, par exemple en argent, qui présente l'avantage d'accroitre le rendement énergétique du dispositif optoélectronique 1. L'anode peut aussi être qualifiée de couche de transport des trous ou HTL (pour *Holes Transport Layer*)*.*

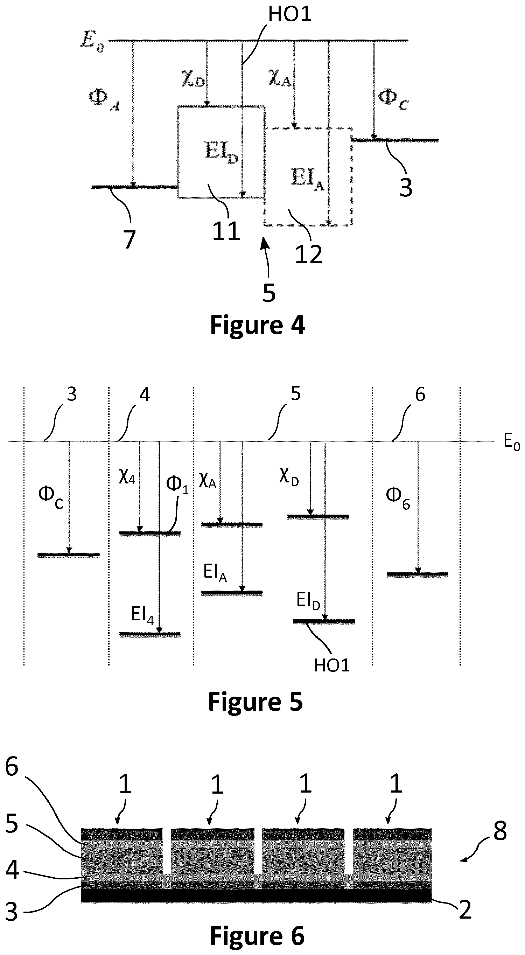

Dans des modes de réalisation de l'invention, le travail de sortie Φ₁ de la couche de collection des électrons 4 et le niveau énergétique de la plus haute orbitale moléculaire occupée, notée HO1, du matériau de type p de la couche active 5 forment une barrière de potentiel apte à bloquer l'injection de trous depuis la cathode 3 vers la couche active 5. Cette barrière est strictement supérieure à 0,3 eV, préférentiellement strictement supérieure à 0,4 eV et préférentiellement strictement supérieure à 0,5 eV. Le détail des niveaux énergétiques des différentes couches du dispositif est décrit dans la figure 5.

Dans un mode de réalisation de l'invention, le dispositif optoélectronique est adapté à être éclairé par le dessus. L'anode 7 peut être dans ce cas transparente. Ce mode de réalisation permet d'éviter la diffusion des rayons lumineux incidents au travers du substrat, et d'obtenir une meilleure résolution dans le cas d'un arrangement matriciel de plusieurs dispositifs optoélectroniques 1.

La figure 4 illustre un diagramme de bande correspondant à une structure d'un dispositif optoélectronique selon l'art antérieur. Le travail de sortie de l'anode 7 (noté Φ_{A}) et de la cathode 3 (noté Φ_{C}) sont définis comme la différence d'énergie entre le niveau de Fermi du matériau de chacune des couches et le niveau d'énergie du vide E₀. L'affinité électronique de la couche active 5 est définie par la différence d'énergie entre la plus basse orbitale moléculaire vacante (dite BV ou LUMO) de la couche active 5 et le niveau énergétique du vide E₀, et peut être respectivement noté χ_{D} et χ_{A} pour le matériau donneur 11 de la couche active 5 et le matériau accepteur 12 de la couche active 5. L'énergie d'ionisation de la couche active 5 est définie par la différence d'énergie entre la plus haute orbitale moléculaire occupée (dite HO ou HOMO) de la couche active 5 et le niveau énergétique du vide E₀, et peut être respectivement noté EI_{D} et EI_{A} pour le matériau donneur 11 de la couche active 5 et le matériau accepteur 12 de la couche active 5. La HO du donneur 11 de la couche active 5est notée HO1.

La figure 5 illustre un diagramme de bande correspondant à une structure selon un mode de réalisation de l'invention. La cathode 3 est caractérisée par un travail de sortie noté Φ_{C}. Lors de la réalisation de la cathode 3 en ITO, Φ_{C} = 4,7 eV. La couche de collection des électrons 4 est caractérisée par une affinité électronique χ₄ et par une énergie d'ionisation EI₄. Lors de la réalisation de la couche de collection des électrons 4 en ZnO, χ₄ = 4,2 eV, Φ₁ = 4,2 eV et EI₄ = 7,5 eV. La couche active 5 est caractérisée par une affinité électronique χ_{D} du donneur 11, par une énergie d'ionisation EI_{D} du donneur 11, par une affinité électronique χ_{A} de l'accepteur 12 et par une énergie d'ionisation EI_{A} de l'accepteur. Dans le cas d'un mode de réalisation décrit en figure 3, ces niveaux énergétique peuvent correspondre à χ_{D} = 3,7 eV, EI_{D} = 5,15 eV, χ_{A} = 3,9 eV et EI_{A} = 6,0 eV. La couche de collection des trous 6 est caractérisée par un travail de sortie Φ₆, qui peut être compris entre 4,9 eV et 5,5 eV lors d'une réalisation de la couche en PEDOT:PSS.

Les contacts du dispositif optoélectronique 1 doivent avoir un travail de sortie adapté pour optimiser l'injection et surtout, dans le cadre de l'application décrite, la collection des charges photo-générées. De manière idéale, le travail de sortie de l'anode 7 est aligné sur la HO du donneur 11 HO1 de la couche active 5 et le travail de sortie de la cathode 3 est aligné sur la LUMO de l'accepteur 12 de la couche active 5.

Dans des modes de réalisations de l'invention, une cathode 3 en ITO a un travail de sortie (par exemple mesuré par une sonde Kelvin) compris dans une gamme allant de 4,6 eV à 5 eV. Par ailleurs, la plupart des matériaux donneurs 11 de l'art antérieur ont un potentiel d'ionisation compris dans une gamme allant de 4,6 eV à 5.4 eV. Une solution technique, pour éviter l'injection parasite de trous d'une cathode 3 en ITO vers le matériau donneur 11 de la couche active 5 est de diminuer le travail de sortie du matériau en contact avec la couche active 5, par exemple en déposant une couche entre la cathode 3 et la couche active 5, correspondant à la couche de collection des électrons 4.

Dans ce mode de réalisation du dispositif optoélectronique 1, on évite l'injection de trous parasites de la cathode 3 vers la couche active 5 et par conséquent on peut minimiser ou supprimer le courant d'obscurité du dispositif optoélectronique 1. Ainsi, dans des modes de réalisation de l'invention, le travail de sortie Φ₁ de la couche de collection des électrons 4 est strictement inférieur au travail de sortie Φ_{C} de la cathode 3 : les injections de trous parasites peuvent ainsi être minimisées. De manière générale, dans un mode de réalisation de l'invention, une couche de collection des électrons 4 permet à une structure de photodiode inverse de former une ou plusieurs barrières de potentiel aptes à bloquer l'injection de trous depuis ladite cathode 3 vers ladite couche active 5. Cette barrière de potentiel peut être à l'interface entre la couche active 5 et la couche de collection des électrons 4 et/ou à l'interface entre la couche de collection des électrons 4 et la cathode 3.

On peut aussi utiliser de la polyéthylènimine ethoxylée (PEIE pour *ethoxylated polyethylenimine* en anglais) pour réaliser la couche de collection des électrons 4. Dans des modes de réalisation de l'invention, on peut utiliser une couche d'argent évaporé comme anode 7 et un matériau choisi parmi du PEDOT:PSS ou des oxydes métalliques, comme du NiₓO_{y}, CuₓO_{y} ou MoₓO_{y} pour réaliser la couche de collection des trous 6.

La figure 6 illustre schématiquement un dispositif optoélectronique matriciel 8 selon un mode de réalisation de l'invention. Un dispositif optoélectronique matriciel 8 selon l'invention comporte une pluralité de dispositifs optoélectroniques 1. Par exemple, quatre dispositifs optoélectroniques 1 sont représentés dans la figure 6. Un dispositif optoélectronique matriciel 8 comporte, selon un mode de réalisation de l'invention, une couche de collection des électrons 4 commune à au moins une partie des dispositifs optoélectroniques 1 et matériellement continue entre chacun des dispositifs optoélectroniques 1 de la partie. Dans des modes de réalisations de l'invention, la couche de collection des électrons 4 communes a une résistance par carré strictement supérieure à 10⁸ Ω, préférentiellement strictement supérieure à 10¹⁰ Ω et préférentiellement strictement supérieure à 10¹¹ Ω, et peut être apte à bloquer les courants de porteurs de charges entre lesdits dispositifs optoélectroniques 1 de ladite ou desdites parties, dans ledit matériau de ladite couche de collection des électrons 4 commune. De cette manière, on peut empêcher les courants de fuite entre différents dispositifs optoélectroniques 1 d'une même matrice, tout en déposant la couche de collection des électrons 4 commune sans étape de lithographie supplémentaire.

Dans des modes de réalisation privilégiés de l'invention, la couche de collection des électrons 4 commune est en ZnO. L'épaisseur de la couche de collection des électrons 4 commune peut être supérieure à 1 nm, de préférence comprise entre 5 et 500 nm et préférentiellement comprise entre 10 et 40 nm. La couche de collection des électrons 4 commune est, par exemple, déposée par pulvérisation cathodique.

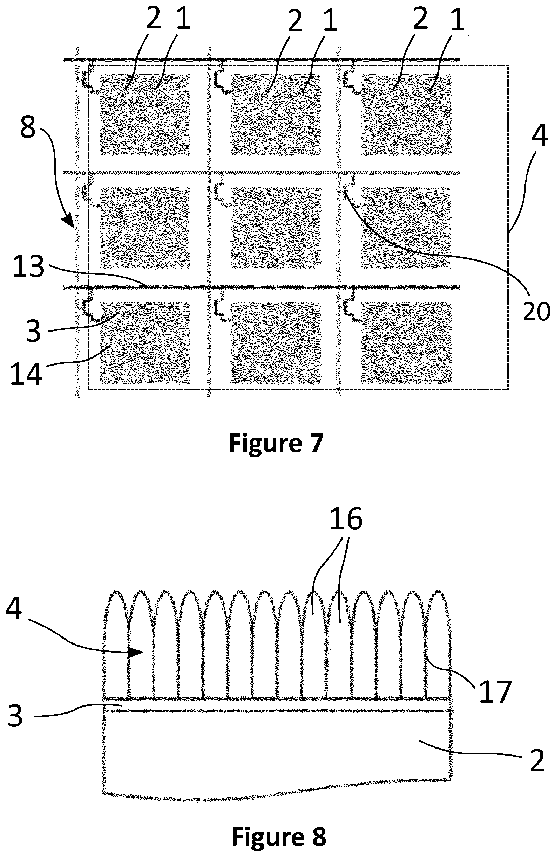

La figure 7 illustre schématiquement un dispositif optoélectronique matriciel 8, en vue de dessus, selon un mode de réalisation de l'invention. Des lignes 13 et des colonnes 14, réalisées en matériau électriquement conducteur, sont reliées à une matrice de TFT 20, permettant de multiplexer les connexions électriques entre chacun des dispositifs optoélectroniques 1 et l'extérieur du dispositif optoélectronique matriciel 8, en vue d'une polarisation et/ou d'une récupération des charges générées par illumination.

Les zones grises carrées illustrées dans la figure 7 correspondent aux limites des dispositifs optoélectroniques 1, agencés dans la partie grise. Chaque TFT 20 est relié électriquement à une électrode inférieure du dispositif optoélectronique matriciel 8, par exemple une cathode 3 dont la géométrie est aussi définie par un carré gris. Le carré en pointillés noirs correspond à un exemple de zone de dépôt de la couche de collection des électrons 4 commune. Cette illustration est schématique pour la compréhension du système : une couche de collection des électrons 4 commune peut recouvrir plusieurs millions de cathodes 3.

La figure 8 illustre schématiquement une coupe dans la direction de l'épaisseur des couches d'une partie d'un dispositif optoélectronique 1, comportant une couche de collection des électrons 4 comportant des cristallites 16. Les cristallites 16 sont agencées en colonnes dans le sens de l'épaisseur de la couche de collection des électrons 4. Dans un mode de réalisation de l'invention, la couche de collection des électrons 4 commune comporte une pluralité de cristallites 16. Avantageusement, le matériau de la couche de collection des électrons 4 est déposé de manière à croître en colonne à partir de la cathode 3. De cette manière, la conductivité latérale de la couche de collection des électrons 4 (c'est-à-dire dans une direction du plan principal de la couche de collection des électrons 4) est limitée grâce à la présence de défauts de type joints de grains 17. Dans le mode de réalisation illustré en figure 8, la conductivité de la couche de collection des électrons 4 est sensiblement inchangée dans la direction de l'épaisseur de la couche par rapport à une organisation isotrope du matériau de la couche de collection des électrons 4. En revanche, la résistance dans une direction du plan principal de la couche est dépendante de la densité de joints de grains 17 et/ou de cristallites 16. La température de dépôt du matériau de la couche de collection des électrons 4 est aussi une variable de cette résistance latérale. La température de dépôt influence la taille des cristallites de la couche de collection des électrons 4. Particulièrement, lorsque la taille des cristallites 16 augmente (lors d'une augmentation de la température de dépôt par exemple), la densité des joints 17 entre les cristallites 16 diminue est la résistance latérale diminue. A *contrario,* si la taille des cristallites 16 diminue, la diffusion par les joints 17 de cristallites 16 devient prépondérante et la résistance latérale augmente. De manière plus générale, dans des modes de réalisation de l'invention, la résistivité du matériau de la couche de collection des électrons 4 commune est moins élevée dans la direction de l'épaisseur de ladite couche de collection des électrons 4 que dans une direction du plan principal de ladite couche de collection des électrons 4. Encore plus généralement, la résistivité du matériau de la couche de collection des électrons 4 est anisotrope dans l'invention.

Dans des modes de réalisation de l'invention, le travail de sortie du matériau de la couche de collection des électrons 4, comme celui de ZnO, est préférentiellement compris entre 4 eV et 4,7 eV pour Φ_{C} = 4,7 eV, χ_{D} = 3,7 eV, EI_{D} = 5,15 eV. Un travail de sortie de ce matériau inférieur à 4,7 eV permet de garantir le fonctionnement du dispositif optoélectronique 1 ou du dispositif optoélectronique matriciel 8, et un travail de sortie supérieur à 4 eV permet de minimiser ou supprimer l'injection de porteurs de charges parasites dans le dispositif optoélectronique ou le dispositif optoélectronique matriciel 8.

De manière générale, l'oxyde de zinc non dopé est considéré comme un semi-conducteur de type n. Le procédé par lequel la couche de collection des électrons 4 est déposée, en particulier quand le matériau est ZnO, permet de changer ses propriétés de conduction électrique. Pour une température de dépôt ambiante, et une atmosphère comportant plus de 1% en masse de dioxygène, préférentiellement plus de 2% en masse de dioxygène, la résistance d'une couche de collection des électrons 4 en ZnO est comprise entre 10⁹ et 10¹² Ω/□. Pour une température de dépôt comprise entre 100 °C et 400 °C, et en présence de dioxygène, la résistance au carré est sensiblement constante et égale à 1 Ω/□.

D'une manière plus générale, un mode de réalisation de l'invention est un procédé de fabrication d'un dispositif optoélectronique 1 et/ou d'un dispositif optoélectronique matriciel 8 comportant au moins une étape consistant à déposer le matériau d'une couche de collection des électrons 4 par une méthode de dépôt de couche mince physique, par exemple par pulvérisation cathodique, à une température comprise entre 0°C et 100°C inclus, dans une atmosphère comportant au moins 1% massique de dioxygène, et préférentiellement 2% massiques de dioxygène.

La résistance de la couche de dépôt est réduite par un recuit (traitement thermique) après un dépôt réalisé à une température comprise entre 0°C et 100°C. Par exemple, pour une couche de collection des électrons 4 en ZnO, un traitement thermique à une température supérieure à 200°C entraîne une résistance par carré comprise entre 10 Q/□ et 10⁹ Ω/□. Cette diminution de la résistance par traitement thermique peut être attribuée à l'oxydation du ZnO en présence d'air. On peut ajuster la résistance d'une couche de collection des électrons 4 selon le procédé de dépôt et de recuit de ladite couche.

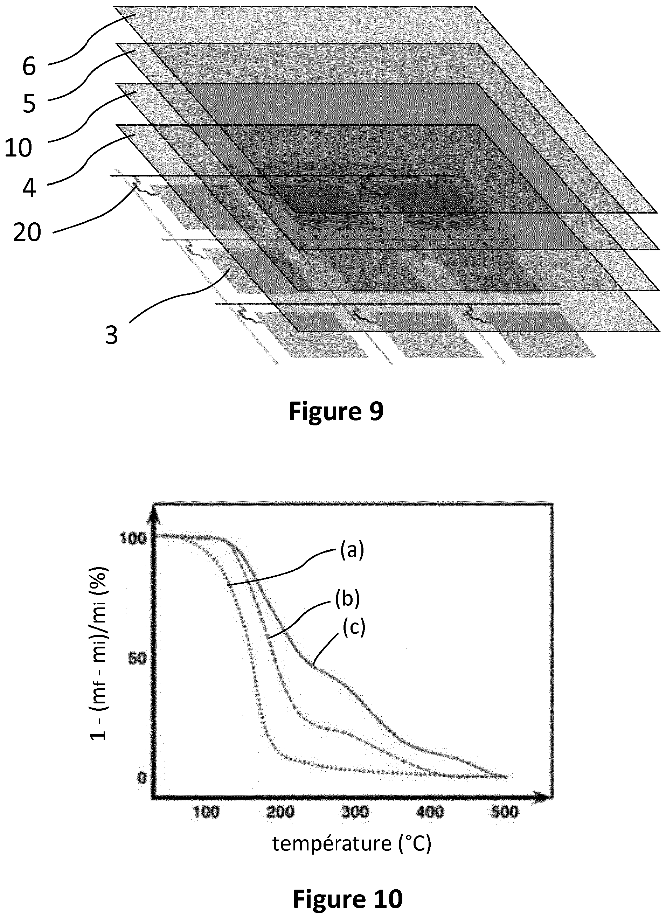

La figure 9 illustre schématiquement les couches minces agencées sur un substrat d'un dispositif optoélectronique matriciel 8 selon un mode de réalisation de l'invention. Les différentes couches sont espacées pour la compréhension du schéma bien qu'elles soient en contact direct dans un mode de réalisation de l'invention. En fonction des paramètres technologiques utilisés lors de la réalisation d'un dispositif optoélectronique matriciel 8, la résistivité du ZnO d'une couche de collection des électrons 4 ne suit pas une évolution simple avec la température de dépôt ou de recuit postérieur au dépôt. La résistivité du matériau de la couche de collection des électrons 4 peut aussi dépendre de son environnement. Par exemple, en présence d'oxygène, un processus d'adsorption et de désorption s'effectue en surface de la couche de collection des électrons 4. Des molécules oxydantes à l'état gazeux, tel que le dioxygène, peuvent être adsorbées à la surface du ZnO et être transformées en ions négatifs O₂⁻. Ce processus crée une zone appauvrie en porteurs de charge libres et diminue la conductivité de la surface de la couche de collection des électrons 4 selon l'équation 1:

O₂^{(gaz)} + e⁻ → O₂^{- (adsorbé)} (1)

En présence d'un éclairement, les trous photo-générés peuvent se déplacer vers la surface de la couche de collection des électrons 4 et neutraliser les ions négatifs d'oxygène. Cela conduit à une augmentation de la conductivité à la surface de la couche de collection des électrons 4 selon l'équation 2:

O₂⁻ + h⁺ → O₂^{(gaz)} (2)

La résistivité et le travail de sortie du matériau de la couche de collection des électrons 4 sont sensibles à la lumière, comme expliqué précédemment. Afin de stabiliser la couche de collection des électrons 4, on peut déposer au dessus de la couche de collection des électrons 4 une couche de stabilisation 10, qui présente une plus grande stabilité à la lumière. Cette couche de stabilisation 10 peut par exemple être réalisée en oxyde d'étain (SnOₓ) ou d'oxyde de palladium (PdOₓ) dont les résistances sont élevées, par exemple strictement supérieures à 10⁸ Ω/□ et préférentiellement strictement supérieures à 10¹⁰ Ω/□. Une couche de stabilisation 10 peut être plus généralement réalisée en matériau de type oxyde opaque. L'épaisseur d'une couche de stabilisation 10 est par exemple comprise entre 1 et 500 nm et préférentiellement comprise entre 10 et 50 nm. De manière générale, dans un mode de réalisation de l'invention, un dispositif optoélectronique matriciel 8 comporte une couche de stabilisation 10 agencée entre une couche de collection des électrons 4 commune et au moins un couche active 5, la couche de stabilisation 10 étant apte à réduire la dépendance de la résistivité du matériau de la couche de collection des électrons 4 commune en fonction de la luminosité. Dans la figure 9, chaque carré gris correspond à une couche déposée pour la réalisation d'un dispositif optoélectronique matriciel 8 : une couche de stabilisation 10 est déposée entre la couche de collection des électrons 4 commune et une ou plusieurs couches actives 5. Dans des modes de réalisation de l'invention, la couche de collection des électrons 4, la couche de stabilisation 10, la couche active 5, et/ou la couche de collection des trous 6 peuvent être communes à une partie ou à l'ensemble des dispositifs optoélectroniques 1 du dispositif optoélectronique matriciel 8.

Une couche de collection des électrons 4 peut être dopée par des éléments, ou impuretés de type p. Ces éléments sont par exemple du cuivre, du nickel, du cobalt, du palladium, du molybdène, du manganèse et/ou du fer. Une impureté de type p présente dans une couche de collection des électrons 4, par exemple en ZnO, permet de limiter la conductivité électrique associée à des porteurs de charges positifs (trous) qui bloquent le courant électrique et augmentent la résistance du matériau de la couche de collection des électrons 4. De manière générale, une couche de collection des électrons 4 commune peut comporter des éléments de type p, et avantageusement du palladium, du cobalt et/ou du cuivre pour former des oxydes isolants ou semi-conducteurs de type p tels que PdO, CoO ou CuO par exemple.

Dans des modes de réalisation de l'invention, on utilise une méthode sol-gel pour la réalisation d'une couche de collection des électrons 4. La méthode de dépôt par voie sol-gel présente l'avantage d'être simple à mettre en œuvre et peu couteuse. La mise en œuvre d'un procédé sol-gel est décrite ultérieurement. Dans un mode de réalisation de l'invention, un procédé pour la fabrication d'un dispositif optoélectronique 1 et/ou d'un dispositif optoélectronique matriciel 8 comporte au moins une étape consistant à former une dite couche de collection des électrons 4 par un procédé sol-gel, le procédé sol-gel comportant une étape de dépôt d'une solution comportant des polymères précurseurs 15. Les dits polymères précurseurs 15 peuvent être obtenus à partir d'acétates métalliques, de nitrates métalliques et/ou de chlorures métalliques.

Un procédé sol-gel ne nécessite pas d'équipement lourd et spécifique, contrairement à une méthode de pulvérisation dans un vide partiel. Ce procédé consiste à étaler avec une tournette ou avec des équipements d'impression (jet d'encre, sérigraphie) sur un substrat une solution comportant un solvant et des polymères précurseurs 15 du matériau de la couche de collection des électrons 4, par exemple de ZnO. Le solvant est ensuite évaporé et un traitement thermique peut permettre ensuite de cristalliser la couche formée. Généralement, une couche déposée est peu dense et très résistive si la température de traitement thermique post-dépôt est inférieure à 400°C. Dans le cas de la formation de ZnO, la couche de collection des électrons 4 comporte du ZnO et des résidus organiques provenant de la synthèse (par exemple des polymères précurseurs 15, additifs et/ou solvant). Ces résidus de synthèse influencent la conductivité électrique d'une couche de collection des électrons 4.

La figure 10 illustre dans un diagramme la variation de la concentration normalisée de polymères précurseurs 15 d'une réaction sol-gel, par analyse gravimétrique, après un traitement thermique ultérieur au dépôt. Plus précisément, le rapport illustré correspond à 1 - (m*_{f}* - m*ᵢ*)/m*ᵢ* , m_{f} étant la masse finale en polymères précurseurs 15 pour une espèce donnée et mᵢ la masse initiale en polymères précurseurs 15 pour une espèce donnée.

La courbe (a), en petits pointillés, illustre ce rapport en fonction de la température du traitement thermique lors de l'utilisation de polymères précurseurs 15 de type nitrate. La courbe (b), en gros pointillés, illustre ce rapport en fonction de la température du traitement thermique lors de l'utilisation de polymères précurseurs 15 de type acétates. La courbe (c), en trait continu, illustre ce rapport en fonction de la température du traitement thermique lors de l'utilisation de polymères précurseurs 15 de type chlorure.

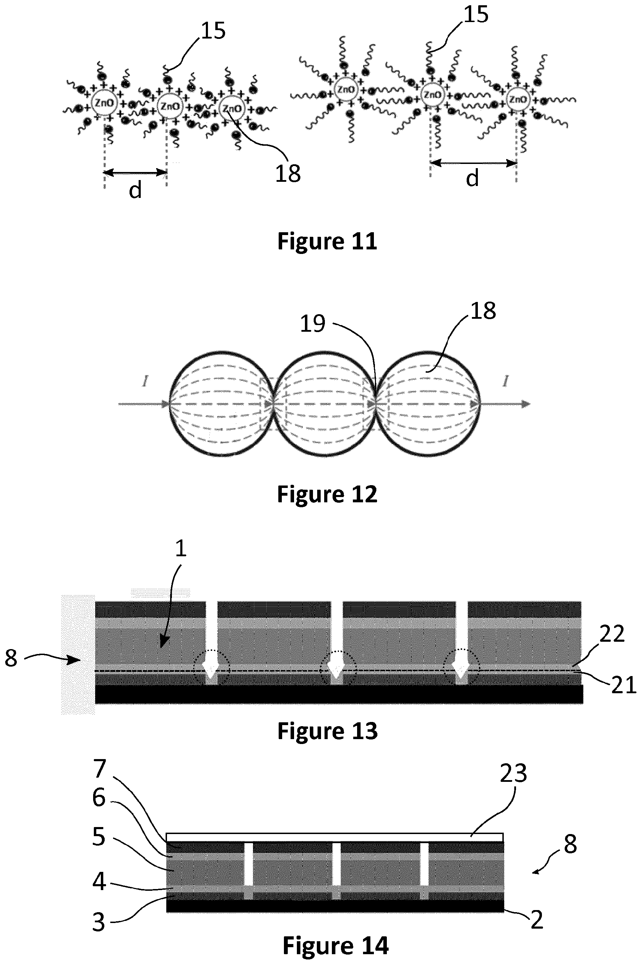

La figure 11 illustre schématiquement l'influence de la taille des polymères précurseurs 15 sur la distance entre des particules de ZnO. La nature chimique des polymères précurseurs 15 utilisés est une variable de la distance entre les différentes particules, ou agrégats 18 de ZnO formés lors du procédé sol-gel. De manière générale, la résistance électrique d'une couche de collection des électrons 4 varie proportionnellement avec la distance d entre les agrégats 18 plus proches voisins de ZnO. Dans des modes de réalisation de l'invention, la température du traitement thermique ultérieur au dépôt et la distance d peuvent être ajustés de manière à ce que la résistance par carré minimal du matériau d'une couche de collection des électrons 4 soit supérieure à 10⁸ Ω/□.

La figure 12 illustre schématiquement la diminution de la conductivité électrique lors de la présence de résidus organiques 19 dans une couche de collection des électrons 4. Les traits en pointillés illustrent des lignes de courants dans des agrégats 18 de ZnO : les résidus 19 sont concentrés aux joints entre les agrégats 18. Les constrictions formées entre les agrégats 18 et la présence de résidus19 dans ces constrictions sont aptes à rendre le matériau plus résistif électriquement.

Dans un mode de réalisation de l'invention, on peut utiliser un procédé de dépôt sol-gel qualifié de procédé par « voie de polymérisation complexe ». Ce procédé comprend les étapes consistant à :
- ajouter des acétates métalliques et/ou nitrates métalliques et/ou chlorures métalliques dans un solvant de 2-méthoxyéthanol agité, à 50°C, jusqu'à obtenir la dissolution leur dissolution dans le solvant :
- former un complexe métallique par un ajout d'acide acétique éthanolamine dans le solvant, à 70°C. Les ions formés sont des ions acétates et métalliques ;
- attendre pendant une réaction de polymérisation jusqu'à obtention de polymères précurseurs 15, en agitant le solvant, à 70°C ;
- déposer la solution de polymères précurseurs 15 sur une cathode 3.

Ce procédé présente les avantages d'être adapté à la synthèse de matériaux d'oxydes mixtes ou complexes à partir de sels métalliques communs, tels que les chlorures, les acétates et/ou les nitrates. Avantageusement, on choisit d'utiliser des acétates lors de la mise en œuvre du procédé décrit au paragraphe précédent : ils sont insensibles à la présence d'eau en solution et donc plus stables. On évite alors de devoir mettre en œuvre le procédé sous atmosphère inerte en utilisant des acétates. Avantageusement, les acétates forment après décomposition partielle des oxydes électriquement stables. Leur utilisation permet de réaliser des couches de collection des électrons 4 de manière reproductible. L'emploi d'acide acétique permet d'éviter la précipitation des ions métalliques lors de la seconde étape du procédé sol-gel décrite précédemment, et d'augmenter la durée de vie de la solution préparée pour la mise en ouvre du procédé sol-gel. L'éthanolamine est un complexant et permet de stabiliser et favoriser l'étape de polymérisation du procédé.

Dans un mode de réalisation, on peut ajouter des éléments dopants de type p (Pd, Cu, Ni, Co) au cours du procédé sol-gel de manière à diminuer la conductivité de la couche de collection des électrons 4 après traitement thermique.

Dans un mode de réalisation de l'invention, on forme une couche de collection des électrons 4 en déposant des nanoparticules de ZnO, greffées de PEIE (polyéthylènimine ethoxylée). Par nanoparticule, on entend une particule dont la taille caractéristique, tel que le diamètre pour une sphère, est comprise entre 0,1 nm et 100 nm. Le PEIE étant un polymère isolant, les couches de collection des électrons 4 réalisées avec des nanoparticules de ZnO greffées par du PEIE ont une résistance par carré très élevée, par exemple supérieure à 10¹⁰ Ω/□. Le PEIE peut être greffé aux particules de ZnO par des groupements amines ou hydroxyles. De manière plus générale, un dispositif optoélectronique 1 et/ou un dispositif optoélectronique matriciel 8 peut comporter des nanoparticules d'oxyde métallique et des polymères polaires greffés sur les nanoparticules d'oxyde métallique.

La figure 13 illustre schématiquement un dispositif optoélectronique matriciel 8 dans lequel la résistance d'une couche de collection des électrons 4 est augmentée par une réalisation de ladite couche en deux étapes de dépôt, formant deux types de sous-couches. Les deux sous-couches sont séparées par des traits en pointillés sur la figure 13. Un premier dépôt peut être réalisé, formant première une sous-couche 21 d'une épaisseur comprise par exemple entre 10 nm et 15 nm. Cette première sous-couche 21 est commune, et déposée entre les dispositifs optoélectronique 1 (c'est-à-dire entre les différents pixels). Un second dépôt peut être réalisé formant une pluralité de secondes sous-couches 22 plus épaisses. Le dépôt des sous-couches 22 est réalisé selon un motif correspondant au motif de l'agencement des dispositifs optoélectroniques 1. Le dépôt des secondes sous-couches 22 peut être réalisé au travers d'un masque métallique gravé aux endroits correspondant aux dispositifs optoélectroniques 1.

Dans un procédé de fabrication d'un dispositif optoélectronique matriciel 8, on peut réduire l'épaisseur d'une couche de collection des électrons 4 entre des dispositifs optoélectroniques 1 de manière à augmenter localement la résistance par carré de la couche de collection des électrons 4.

Dans un mode de réalisation de l'invention, au moins un élément choisi parmi un substrat 2, une cathode 3, une couche de collection des électrons 4, une couche active 5, une couche de collection des trous 6 et une anode 7 est transparent.

La figure 14 illustre un mode de réalisation de l'invention dans lequel un dispositif optoélectronique matriciel 8 comporte une couche de matériau scintillateur 23. Dans des modes de réalisation de l'invention, une couche de matériau scintillateur 23 peut être agencée sur chacune des anodes 7 du dispositif optoélectronique matriciel 8. Par matériau scintillateur, on entend un matériau apte à emmètre de la lumière, par exemple dans le spectre du visible, suite à l'absorption d'un rayonnement ionisant, par exemple suite à l'absorption de rayons X. Avantageusement, une couche de collection des trous 6 et une anode 7 sont transparente dans ce mode de réalisation. Ainsi le dispositif 8 peut être apte à imager les rayons X.

Dans des modes de réalisation de l'invention, la détection de rayons X peut être directement réalisée dans la couche active. Dans ce cas, il n'est pas nécessaire que le substrat 2, la cathode 3, la couche de collection des électrons 4, la couche de collection des trous 6 et/ou l'anode 7 soient transparents.

## Revendications

1. Dispositif optoélectronique (1) comprenant un empilement de couches minces planaires agencées sur un substrat (2) électriquement isolant, dont au moins :
- une cathode (3) réalisée dans un matériau de travail de sortie Φ_{C} ;
- une couche de collection des électrons (4) agencée au dessus de ladite cathode (3), réalisée dans un matériau de travail de sortie Φ₁ et de résistance par carré R ;
- une couche active (5) comprenant au moins un matériau semi-conducteur organique de type p, de niveau énergétique de la plus haute orbitale moléculaire occupée HO1 et un matériau semi-conducteur organique de type n, adaptée pour émettre ou détecter un rayonnement lumineux, agencée au dessus de ladite couche de collection des électrons (4) ;
- une couche de collection des trous (6), agencée au dessus de ladite couche active (5) ;
- une anode (7), agencée au dessus de ladite couche de collection des trous (6) ;
- ledit travail de sortie Φ₁ de ladite couche de collection des électrons (4) et ledit niveau énergétique HO1 de ladite couche active (5) forment une barrière de potentiel apte à bloquer l'injection de trous depuis ladite cathode (3) vers ladite couche active (5) ;
- ladite résistance par carré R de ladite couche de collection des électrons (4) est supérieure ou égale à 10⁸ Ω,
**caractérisé en ce que**:
- ladite couche de collection des électrons (4) est continue et comporte des cristallites (16) agencées en colonnes dans la direction de l'épaisseur de ladite couche de collection des électrons (4), induisant une anisotropic de la résistivité dudit matériau de ladite couche de collection des électrons (4), ladite résistivité étant moins élevée dans la direction de l'épaisseur de ladite couche de collection des électrons (4) que dans une direction du plan principal de ladite couche de collection des électrons (4).

2. Dispositif optoélectronique (1) selon la revendication précédente dans lequel ledit travail de sortie Φ₁ de ladite couche de collection des électrons (4) est strictement inférieur audit travail de sortie Φ_{C} de ladite cathode (3).

3. Dispositif optoélectronique (1) selon l'une des revendications précédente dans lequel ledit matériau de ladite couche de collection des électrons (4) est choisi parmi l'oxyde de zinc et l'oxyde de titane.

4. Dispositif optoélectronique matriciel (8) comportant une pluralité de dispositifs optoélectroniques (1) selon l'une des revendications 1 à 3 et une couche de collection des électrons (4) commune à au moins une partie desdits dispositifs optoélectroniques (1) et matériellement continue entre chacun desdits dispositifs optoélectroniques (1).

5. Dispositif optoélectronique matriciel (8) selon la revendication 4 dans lequel ladite résistance par carré R de ladite couche de collection (4) commune est apte à bloquer les courants de porteurs de charges entre lesdits dispositifs optoélectroniques (1) de ladite ou desdites parties, dans ledit matériau de ladite couche de collection (4) commune.

6. Dispositif optoélectronique matriciel (8) selon l'une des revendications 4 à 5 comportant au moins une couche de stabilisation (10) agencée entre ladite couche de collection des électrons (4) commune et au moins une couche active (5), dans lequel ladite couche de stabilisation (10) est apte à réduire la dépendance de la résistivité du matériau d'une dite couche de collection des électrons (4) commune en fonction de la luminosité.

7. Dispositif optoélectronique matriciel (8) selon la revendication 6 dans lequel le matériau de ladite couche de stabilisation (10) est un oxyde opaque de préférence choisi parmi de l'oxyde d'étain, l'oxyde de palladium.

8. Dispositif optoélectronique matriciel (8) selon l'une des revendications 4 à 7 dans lequel le matériau de ladite couche de collection des électrons (4) commune comporte des éléments dopants de type p.

9. Dispositif optoélectronique matriciel (8) selon la revendication précédente dans lequel lesdits éléments dopants de type p sont choisis parmi le palladium, le cobalt, le cuivre et le molybdène.

10. Dispositif optoélectronique matriciel (8) selon l'une des revendications 4 à 9 dans lequel ladite couche de collection des électrons comporte des nanoparticules d'oxyde métallique et des polymères polaires, lesdits polymères polaires étant greffés sur lesdites nanoparticules d'oxyde métallique.

11. Dispositif optoélectronique matriciel (8) selon l'une des revendications 4 à 10 dans lequel au moins un élément choisi parmi le substrat (2), la cathode (3), la couche de collection des électrons (4), la couche active (5), la couche de collection des trous (6) et l'anode (7) est transparent.

12. Dispositif optoélectronique matriciel (8) selon la revendication précédente comportant une couche de matériau scintillateur (23), ladite couche étant agencée au dessus de chaque dite anode (7).

13. Procédé de fabrication d'un dispositif optoélectronique (1,8) selon l'une des revendications 1 à 12 comprenant un empilement de couches minces planaires agencées sur un substrat (2) électriquement isolant, dont au moins :
- une cathode (3) réalisée dans un matériau de travail de sortie Φ_{C} ;
- une couche de collection des électrons (4), agencée au dessus de ladite cathode (3), réalisée dans un matériau de travail de sortie Φ₁ et de résistance par carré R, ladite couche de collection des électrons (4) étant continue et comportant des cristallites (16) agencées en colonnes dans la direction de l'épaisseur de ladite couche de collection des électrons (4), induisant une anisotropie de la résistivité dudit matériau de ladite couche de collection des électrons (4), ladite résistivité étant moins élevée dans la direction de l'épaisseur de ladite couche de collection des électrons (4) que dans une direction du plan principal de ladite couche de collection des électrons (4).
- une couche active (5) comprenant au moins un matériau semi-conducteur organique de type p, de niveau énergétique de la plus haute orbitale moléculaire occupée HO1 et un matériau semi-conducteur de type n, adaptée pour émettre ou détecter un rayonnement lumineux, agencée au dessus de ladite couche de collection des électrons (4) ;
- une couche de collection des trous (6), agencée au dessus de ladite couche active (5) ;
- une anode (7), agencée au dessus de ladite couche de collection des trous (6) ;
comportant au moins une étape consistant à déposer le matériau d'une dite couche de collection des électrons (4) par pulvérisation cathodique à une température comprise entre 0°C et 100°C dans une atmosphère comportant au moins 1% massique de dioxygène.

14. Procédé de fabrication d'un dispositif optoélectronique (1,8) selon l'une des revendications 1 à 12 comprenant un empilement de couches minces planaires agencées sur un substrat (2) électriquement isolant, dont au moins :
- une cathode (3) réalisée dans un matériau de travail de sortie Φ_{C} ;
- une couche de collection des électrons (4) agencée au dessus de ladite cathode (3), réalisée dans un matériau de travail de sortie Φ₁ et de résistance par carré R, ladite couche de collection des électrons (4) étant continue et comportant des cristallites (16) agencées en colonnes dans la direction de l'épaisseur de ladite couche de collection des électrons (4), induisant une anisotropie de la résistivité dudit matériau de ladite couche de collection des électrons (4), ladite résistivité étant moins élevée dans la direction de l'épaisseur de ladite couche de collection des électrons (4) que dans une direction du plan principal de ladite couche de collection des électrons (4).
- une couche active (5) comprenant au moins un matériau semi-conducteur organique de type p, de niveau énergétique de la plus haute orbitale moléculaire occupée HO1 et un matériau semi-conducteur de type n, adaptée pour émettre ou détecter un rayonnement lumineux, agencée au dessus de ladite couche de collection des électrons (4) ;
- une couche de collection des trous (6), agencée au dessus de ladite couche active (5) ;
- une anode (7), agencée au dessus de ladite couche de collection des trous (6) ;
ledit procédé comportant au moins une étape consistant à former une dite couche de collection des électrons (4) par un procédé sol-gel, ledit procédé sol-gel comportant une étape de dépôt d'une solution comportant des polymères précurseurs (15), lesdits polymères précurseurs (15) étant choisis parmi des acétates métalliques, des nitrates métalliques et des chlorures métalliques.

15. Procédé de fabrication d'un dispositif optoélectronique (1,8) selon la revendication précédente dans lequel ladite solution comporte des éléments dopants de type p.

16. Procédé de fabrication d'un dispositif optoélectronique matriciel (8) selon l'une des revendications 4 à 12 comportant une pluralité de dispositifs optoélectroniques (1) selon l'une des revendications 1 à 3 agencés selon un motif, comprenant une pluralité d'empilements de couches minces planaires agencées sur un substrat (2) électriquement isolant, les couches minces comprenant au moins :
- une pluralité de cathodes (3) réalisées dans un matériau de travail de sortie Φ_{C} ;
- une couche de collection des électrons (4) commune, comportant une première sous-couche commune (21) et une pluralité de secondes sous-couches (22) sur la première sous-couche commune (21), agencée au dessus de chaque dite cathode (3), réalisée dans un matériau de travail de sortie Φ₁ et de résistance par carré R, ladite couche de collection des électrons (4) étant continue et comportant des cristallites (16) agencées en colonnes dans la direction de l'épaisseur de ladite couche de collection des électrons (4), induisant une anisotropie de la résistivité dudit matériau de ladite couche de collection des électrons (4), ladite résistivité étant moins élevée dans la direction de l'épaisseur de ladite couche de collection des électrons (4) que dans une direction du plan principal de ladite couche de collection des électrons (4),
- une pluralité de couches actives (5) comprenant au moins un matériau semi-conducteur organique de type p, de niveau énergétique de la plus haute orbitale moléculaire occupée HO1 et un matériau semi-conducteur de type n, adaptée pour émettre ou détecter un rayonnement lumineux, agencées au dessus de ladite couche de collection des électrons (4) ;
- une pluralité de couches de collection des trous (6), agencées au dessus de ladite pluralité de couches actives (5) ;
- une pluralité d'anodes (7), agencées sur ladite pluralité de couches de collection des trous (6) ;
ledit procédé comportant au moins deux sous-étapes de dépôt de ladite couche de collection des électrons (4) consistant à :
- déposer une première sous-couche (21) de collection des électrons 4-commune ;
- déposer sur ladite première sous-couche de collection des électrons commune (21) une pluralité de secondes sous-couches (22) selon un motif correspondant audit motif desdits dispositifs optoélectroniques (1).

## Patentansprüche

1. Optoelektronisches Bauelement (1) umfassend einen Stapel planarer Dünnschichten, die auf einem elektrisch isolierenden Substrat (2) angeordnet sind, darunter mindestens:
- eine Kathode (3) aus einem Material mit einer Austrittsarbeit Φ_{C};
- eine über der Kathode (3) angeordnete Elektronensammelschicht (4) aus einem Material mit einer Austrittsarbeit Φ₁ und einem Schichtwiderstand R;
- eine aktive Schicht (5), die mindestens ein organisches Halbleitermaterial des p-Typs mit dem Energieniveau des höchsten besetzten Molekülorbitals HO1 und ein organisches Halbleitermaterial des n-Typs umfasst, ausgelegt zum Emittieren oder Detektieren von Lichtstrahlung und angeordnet über der Elektronensammelschicht (4);
- eine Lochsammelschicht (6), die über der aktiven Schicht (5) angeordnet ist;
- eine Anode (7), die über der Lochsammelschicht (6) angeordnet ist;
- die Austrittsarbeit Φ₁ der Elektronensammelschicht (4) und das Energieniveau HO1 der aktiven Schicht (5) bilden eine Potentialbarriere, die die Injektion von Löchern von der Kathode (3) zur aktiven Schicht (5) blockieren kann;
- der Schichtwiderstand R der Elektronensammelschicht (4) ist gleich oder größer als 10⁸ Ω,
**dadurch gekennzeichnet, dass**:
- die Elektronensammelschicht (4) kontinuierlich ist und Kristallite (16) aufweist, die in Spalten in Richtung der Dicke der Elektronensammelschicht (4) angeordnet sind, so dass eine Anisotropie des spezifischen Widerstands des Materials der Elektronensammelschicht (4) induziert wird, wobei der spezifische Widerstand in Richtung der Dicke der Elektronensammelschicht (4) geringer ist als in einer Richtung der Hauptebene der Elektronensammelschicht (4).

2. Optoelektronisches Bauelement (1) nach dem vorherigen Anspruch, wobei die Austrittsarbeit Φ₁ der Elektronensammelschicht (4) strikt kleiner ist als die Austrittsarbeit Φ_{c} der Kathode (3).

3. Optoelektronisches Bauelement (1) nach einem der vorherigen Ansprüche, wobei das Material der Elektronensammelschicht (4) ausgewählt ist aus Zinkoxid und Titanoxid.

4. Optoelektronisches Matrix-Bauelement (8), das eine Mehrzahl von optoelektronischen Bauelementen (1) nach einem der Ansprüche 1 bis 3 und eine Elektronensammelschicht (4) umfasst, die mindestens einem Teil der optoelektronischen Bauelemente (1) gemein ist und zwischen den einzelnen optoelektronischen Bauelementen (1) materiell durchgehend ist.

5. Optoelektronisches Matrix-Bauelement (8) nach Anspruch 4, wobei der Schichtwiderstand R der gemeinsamen Sammelschicht (4) so ausgelegt ist, dass er Ladungsträgerströme zwischen den optoelektronischen Bauelementen (1) des/der Teils/-e in dem Material der gemeinsamen Sammelschicht (4) blockiert.

6. Optoelektronisches Matrix-Bauelement (8) nach einem der Ansprüche 4 bis 5, das mindestens eine Stabilisierungsschicht (10) umfasst, die zwischen der gemeinsamen Elektronensammelschicht (4) und mindestens einer aktiven Schicht (5) angeordnet ist, wobei die Stabilisierungsschicht (10) die Abhängigkeit des spezifischen Widerstands des Materials der gemeinsamen Elektronensammelschicht (4) entsprechend der Helligkeit verringern kann.

7. Optoelektronisches Matrix-Bauelement (8) nach Anspruch 6, wobei das Material der Stabilisierungsschicht (10) ein opakes Oxid ist, das vorzugsweise aus Zinnoxid, Palladiumoxid ausgewählt ist.

8. Optoelektronisches Matrix-Bauelement (8) nach einem der Ansprüche 4 bis 7, wobei das Material der gemeinsamen Elektronensammelschicht (4) p-Typ-Dotierungsmittelelemente aufweist.

9. Optoelektronisches Matrix-Bauelement (8) nach dem vorherigen Anspruch, wobei die p-Typ-Dotierungsmittelelemente aus Palladium, Kobalt, Kupfer und Molybdän ausgewählt sind.

10. Optoelektronisches Matrix-Bauelement (8) nach einem der Ansprüche 4 bis 9, wobei die Elektronensammelschicht Metalloxid-Nanopartikel und polare Polymere aufweist, wobei die polaren Polymere auf den Metalloxid-Nanopartikeln aufgewachsen sind.

11. Optoelektronisches Matrix-Bauelement (8) nach einem der Ansprüche 4 bis 10, wobei mindestens ein Element ausgewählt aus dem Substrat (2), der Kathode (3), der Elektronensammelschicht (4), der aktiven Schicht (5), der Lochsammelschicht (6) und der Anode (7) transparent ist.

12. Optoelektronisches Matrix-Bauelement (8) nach dem vorherigen Anspruch mit einer Schicht aus Szintillatormaterial (23), wobei die Schicht über jeder Anode (7) angeordnet ist.

13. Verfahren zur Herstellung eines optoelektronischen Bauelements (1, 8) nach einem der Ansprüche 1 bis 12 aufweisend einen Stapel planarer Dünnschichten (1, 8), die auf einem elektrisch isolierenden Substrat (2) angeordnet sind, darunter mindestens:
- eine Kathode (3) aus einem Material mit einer Austrittsarbeit Q_{c};
- eine Elektronensammelschicht (4), die über der Kathode (3) angeordnet istund aus einem Material mit einer Austrittsarbeit Φᵢ und einem Schichtwiderstand R besteht, wobei die Elektronensammelschicht (4) durchgehend ist und Kristallite (16) aufweist, die in Richtung der Dicke der Elektronensammelschicht (4) in Spalten angeordnet sind, so dass eine Anisotropie des spezifischen Widerstands des Materials der Elektronensammelschicht (4) induziert wird, wobei der spezifische Widerstand in Richtung der Dicke der Elektronensammelschicht (4) geringer ist als in einer Richtung der Hauptebene der Elektronensammelschicht (4);
- eine aktive Schicht (5), die mindestens ein organisches Halbleitermaterial des p-Typs mit dem Energieniveau des höchsten besetzten Molekülorbitals HO1 und ein Halbleitermaterial des n-Typs umfasst, ausgelegt zum Emittieren oder Detektieren einer Lichtstrahlung und angeordnet über der Elektronensammelschicht (4);
- eine Lochsammelschicht (6), die über der aktiven Schicht (5) angeordnet ist;
- eine Anode (7), die über der Lochsammelschicht (6) angeordnet ist;
das mindestens einen Schritt des Anordnens des Materials der Elektronensammelschicht (4) durch kathodische Zerstäubung bei einer Temperatur zwischen 0°C und 100°C in einer Atmosphäre aufweist, die mindestens 1 Gew.-% Sauerstoff enthält.

14. Verfahren zur Herstellung eines optoelektronischen Bauelements (1, 8) nach einem der Ansprüche 1 bis 12 mit einem Stapel planarer Dünnschichten, die auf einem elektrisch isolierenden Substrat (2) angeordnet sind, darunter mindestens:
- eine Kathode (3) aus einem Material mit einer Austrittsarbeit Φ_{c};
- eine Elektronensammelschicht (4), die über der Kathode (3) angeordnet ist und aus einem Material mit einer Austrittsarbeit Φ₁ und einem Schichtwiderstand R hergestellt ist, wobei die Elektronensammelschicht (4) kontinuierlich ist und Kristallite (16) aufweist, die in Spalten in Richtung der Dicke der Elektronensammelschicht (4) angeordnet sind, so dass eine Anisotropie des spezifischen Widerstands des Materials der Elektronensammelschicht (4) induziert wird, wobei der spezifische Widerstand in Richtung der Dicke der Elektronensammelschicht (4) geringer ist als in einer Richtung der Hauptebene der Elektronensammelschicht (4);
- eine aktive Schicht (5), die mindestens ein organisches Halbleitermaterial des p-Typs mit dem Energieniveau des höchsten besetzten Molekülorbitals HO1 und ein Halbleitermaterial des n-Typs aufweist, ausgelegt zum Emittieren oder Detektieren von Lichtstrahlung und angeordnet über der Elektronensammelschicht (4);
- eine Lochsammelschicht (6), die über der aktiven Schicht (5) angeordnet ist;
- eine Anode (7), die über der Lochsammelschicht (6) angeordnet ist; wobei das Verfahren mindestens einen Schritt aufweist, der darin besteht, eine Elektronensammelschicht (4) durch ein Sol-Gel-Verfahren zu bilden, wobei das Sol-Gel-Verfahren einen Schritt des Absetzens einer Lösung aufweist, die Vorläuferpolymere (15) aufweist, wobei die Vorläuferpolymere (15) aus Metallacetaten, Metallnitraten und Metallchloriden ausgewählt sind.

15. Verfahren zur Herstellung eines optoelektronischen Bauelements (1, 8) nach dem vorherigen Anspruch, wobei die Lösung Dotierungsmittelelemente des p-Typs aufweist.

16. Verfahren zur Herstellung eines optoelektronischen Matrix-Bauelements (8) nach einem der Ansprüche 4 bis 12, das eine Mehrzahl von optoelektronischen Bauelementen (1) nach einem der Ansprüche 1 bis 3 aufweist, die in einem Muster angeordnet sind, umfassend eine Mehrzahl von Stapeln planarer Dünnschichten, angeordnet auf einem elektrisch isolierenden Substrat (2), wobei die Dünnschichten mindestens Folgendes umfassen:
- eine Mehrzahl von Kathoden (3) aus einem Material mit einer Austrittsarbeit Φ_{c};
- eine gemeinsame Elektronensammelschicht (4), die eine erste gemeinsame Teilschicht (21) und eine Mehrzahl von zweiten Teilschichten (22) auf der ersten gemeinsamen Teilschicht (21) aufweist, angeordnet über jeder Kathode (3) und gefertigt aus einem Material mit einer Austrittsarbeit Φ₁ und einem Schichtwiderstand R, wobei die Elektronensammelschicht (4) kontinuierlich ist und Kristallite (16) aufweist, die in Richtung der Dicke der Elektronensammelschicht (4) in Spalten angeordnet sind, so dass eine Anisotropie des spezifischen Widerstands des Materials der Elektronensammelschicht (4) induziert wird, wobei der spezifische Widerstand in Richtung der Dicke der Elektronensammelschicht (4) geringer ist als in einer Richtung der Hauptebene der Elektronensammelschicht (4),
- eine Mehrzahl von aktiven Schichten (5), die mindestens ein organisches Halbleitermaterial des p-Typs mit dem Energieniveau des höchsten besetzten Molekülorbitals HO1 und ein Halbleitermaterial des n-Typ umfassen, ausgelegt zum Emittieren und Detektieren von Lichtstrahlung und angeordnet über der Elektronensammelschicht (4);
- eine Mehrzahl von Lochsammelschichten (6), angeordnet über der Mehrzahl von aktiven Schichten (5); und
- eine Mehrzahl von Anoden (7), angeordnet auf der Mehrzahl von Lochsammelschichten (6);
wobei das Verfahren mindestens zwei Teilschritte des Absetzens der Elektronensammelschicht (4) aufweist, bestehend aus:
- Absetzen einer ersten gemeinsamen Elektronensammelteilschicht (21);
- Absetzen einer Mehrzahl von zweiten Teilschichten (22) gemäß einem Muster entsprechend dem Muster der optoelektronischen Bauelemente auf der ersten gemeinsamen Elektronensammelteilschicht (21).

## Claims

1. An optoelectronic device (1) comprising a stack of planar thin layers that are arranged on an electrically insulating substrate (2), including at least:
- one cathode (3) made of a material of work function Φ_{C};
- one electron-collecting layer (4) that is arranged above said cathode (3) and that is made of a material of work function Φ₁ and of sheet resistance R;
- one active layer (5) comprising at least one p-type organic semiconductor, the energy level of the highest occupied molecular orbital of which is HO1, and an n-type organic semiconductor, said layer being suitable for emitting or detecting light radiation and being arranged above said electron-collecting layer (4);
- one hole-collecting layer (6) that is arranged above said active layer (5);
- one anode (7) that is arranged above said hole-collecting layer (6);
- said work function Φ₁ of said electron-collecting layer (4) and said energy level HO1 of said active layer (5) form a potential barrier able to block the injection of holes from said cathode (3) into said active layer (5);
- said sheet resistance R of said electron-collecting layer (4) is higher than or equal to 10⁸ Q,
**characterized in that**:
- said electron-collecting layer (4) is continuous and has crystallites (16) arranged in columns in the direction of the thickness of said electron-collecting layer (4), inducing an anisotropy of the resistivity of said material of said electron-collecting layer (4), said resistivity being lower in the direction of the thickness of said electron-collecting layer (4) than in a direction of the main plane of said electron-collecting layer (4).

2. The optoelectronic device (1) according to the preceding claim, wherein said work function Φ₁ of said electron-collecting layer (4) is strictly lower than said work function Φ_{C} of said cathode (3).

3. The optoelectronic device (1) according to one of the preceding claims, wherein said material of said electron-collecting layer (4) is chosen from zinc oxide and titanium oxide.

4. A matrix-array optoelectronic device (8) including a plurality of optoelectronic devices (1) according to one of claims 1 to 3 and an electron-collecting layer (4) that is common to at least one portion of said optoelectronic devices (1) and materially continuous between each of said optoelectronic devices (1).

5. The matrix-array optoelectronic device (8) according to claim 4, wherein said sheet resistance R of said common collecting layer (4) is able to block currents of charge carriers between said optoelectronic devices (1) of said portion or portions, in said material of said common collecting layer (4).

6. The matrix-array optoelectronic device (8) according to one of claims 4 to 5, including at least one stabilizing layer (10) arranged between said common electron-collecting layer (4) and at least one active layer (5), wherein said stabilizing layer (10) is able to decrease the dependency of the resistivity of the material of a said common electron-collecting layer (4) as a function of luminosity.

7. The matrix-array optoelectronic device (8) according to claim 6, wherein the material of said stabilizing layer (10) is an opaque oxide that is preferably chosen from tin oxide and palladium oxide.

8. The matrix-array optoelectronic device (8) according to one of claims 4 to 7, wherein the material of said common electron-collecting layer (4) has p-type dopants.

9. The matrix-array optoelectronic device (8) according to the preceding claim, wherein said p-type dopants are chosen from palladium, cobalt, copper and molybdenum.

10. The matrix-array optoelectronic device (8) according to one of claim 4 to 9, wherein said electron-collecting layer has metal-oxide nanoparticles and polar polymers, said polar polymers being grafted onto said metal-oxide nanoparticles.

11. The matrix-array optoelectronic device (8) according to one of claims 4 to 10, wherein at least one element chosen from the substrate (2), the cathode (3), the electron-collecting layer (4), the active layer (5), the hole-collecting layer (6) and the anode (7) is transparent.

12. The matrix-array optoelectronic device (8) according to the preceding claim, with a layer of scintillator material (23), said layer being arranged above each said anode (7).

13. A process for manufacturing an optoelectronic device (1, 8) according to one of claims 1 to 12 having a stack of planar thin layers that are arranged on an electrically insulating substrate (2), including at least:
- one cathode (3) made of a material of work function Φ_{C};
- one electron-collecting layer (4) that is arranged above said cathode (3) and that is made of a material of work function Φ₁ and of sheet resistance R, said electron-collecting layer (4) being continuous and having cristallites (16) arranged in columns in the direction of the thickness of said electron-collecting layer (4), inducing an anisotropy of the resistivity of said material of said electron-collecting layer (4), said resistivity being lower in the direction of the thickness of said electron-collecting layer (4) than in a direction of the main plane of said electron-collecting layer (4);
- one active layer (5) comprising at least one p-type organic semiconductor, the energy level of the highest occupied molecular orbital of which is HO1, and an n-type semiconductor, said layer being suitable for emitting or detecting light radiation and being arranged above said electron-collecting layer (4);
- one hole-collecting layer (6) that is arranged above said active layer (5);
- one anode (7) that is arranged above said hole-collecting layer (6);
having at least one step of depositing the material of a said electron-collecting layer (4) by cathode sputtering at a temperature comprised between 0°C and 100°C in an atmosphere containing at least 1% by mass dioxygen.

14. A process for manufacturing an optoelectronic device (1, 8) according to one of claims 1 to 12 comprising a stack of planar thin layers that are arranged on an electrically insulating substrate (2), including at least:
- one cathode (3) made of a material of work function Φ_{C};
- one electron-collecting layer (4) that is arranged above said cathode (3) and that is made of a material of work function Φ₁ and of sheet resistance R, said electron-collecting layer (4) being continuous and having cristallites (16) arranged in columns in the direction of the thickness of said electron-collecting layer (4), inducing an anisotropy of the resistivity of said material of said electron-collecting layer (4), said resistivity being lower in the direction of the thickness of said electron-collecting layer (4) than in a direction of the main plane of said electron-collecting layer (4);
- one active layer (5) having at least one p-type organic semiconductor, the energy level of the highest occupied molecular orbital of which is HO1, and an n-type semiconductor, said layer being suitable for emitting or detecting light radiation and being arranged above said electron-collecting layer (4);
- one hole-collecting layer (6) that is arranged above said active layer (5);
- one anode (7) that is arranged above said hole-collecting layer (6);
said process having at least one step of forming a said electron-collecting layer (4) using a sol-gel process, said sol-gel process having a step of depositing a solution having precursor polymers (15), said precursor polymers (15) being chosen from metal acetates, metal nitrates and metal chlorides.

15. The process for manufacturing an optoelectronic device (1, 8) according to the preceding claim, wherein said solution has p-type dopants.

16. A process for manufacturing a matrix-array optoelectronic device (8) according to one of claims 4 to 12 having a plurality of optoelectronic devices (1) according to one of claims 1 to 3 arranged in a pattern, comprising a plurality of stacks of planar thin layers that are arranged on an electrically insulating substrate (2), the thin layers comprising at least:
- a plurality of cathodes (3) made of a material of work function Φ_{C};
- one common electron-collecting layer (4), having a first common sublayer (21) and a plurality of second sublayers (22) on the first common sublayer (21), that is arranged above each said cathode (3) and that is made of a material of work function Φ₁ and of sheet resistance R, said electron-collecting layer (4) being continuous and having cristallites (16) arranged in columns in the direction of the thickness of said electron-collecting layer (4), inducing an anisotropy of the resistivity of said material of said electron-collecting layer (4), said resistivity being lower in the direction of the thickness of said electron-collecting layer (4) than in a direction of the main plane of said electron collecting layer (4);
- a plurality of active layers (5) comprising at least one p-type organic semiconductor, the energy level of the highest occupied molecular orbital of which is HO1, and an n-type semiconductor, said layer being suitable for emitting or detecting light radiation and being arranged above said electron-collecting layer (4);
- a plurality of hole-collecting layers (6) that is arranged above said plurality of active layers (5);
- a plurality of anodes (7) that is arranged above said plurality of hole-collecting layers (6);
said process having at least two sub-steps of depositing said electron-collecting layer (4) consisting in:
- depositing a first common electron-collecting sublayer (21);
- depositing on said first common electron-collecting sublayer (21) a plurality of second sublayers (22) in a pattern corresponding to said pattern of said optoelectronic devices (1).
